# NEW EUROPEAN PATENT SPECIFICATION

(11) **EP 0 111 988 B2**
(45) Date of publication and mention of the opposition decision: **28.08.1996**
(45) Mention of the grant of the patent: 06.09.1989
(21) Application number: 83302419.3
(22) Date of filing: 28.04.1983
(51) Int. Cl.: G11B 11/10, G11C 13/06

(54) **Magneto-optic memory device**
Magnetooptisches Speicherelement
Elément de mémorisation magnéto-optique

(30) Priority: 15.12.1982 JP 220999/82; 17.03.1983 JP 45487/83; 17.03.1983 JP 45488/83
(43) Date of publication of application: 27.06.1984
(60) Divisional application: 88104159.4
(73) Proprietor: SHARP KABUSHIKI KAISHA, Osaka 545 (JP)
(72) Inventor: Ohta, Kenji, Yao-shi Osaka-fu (JP); Takahashi, Akira, Nara-shi Nara-ken (JP); Hirokane, Junji, Tenri-shi Nara-ken (JP); Katayama, Hiroyuki, Nara-shi Nara-ken (JP); Yamaoka, Hideyoshi, Matsubara-shi Osaka-fu (JP)
(74) Representative: Musker, David Charles

(56) References cited:
- EP-A- 0 062 975
- DE-A- 2 303 520
- DE-A- 3 124 573
- FR-A- 2 485 241
- US-A- 3 472 575
- US-A- 3 600 218
- US-A- 4 042 341
- US-A- 4 069 487
- US-A- 4 170 689
- US-A- 4 322 839
- Patent Abstracts of Japan, vol. 5, no. 134; 26 August 1981 & JP-A-56-71834
- APPLIED OPTICS, vol. 13, no. 4, April 1974, New York, D. CHEN "Magnetic material for optical recording" pages 767-777
- Journal of the Electrochemical Society, vol.125, No. 4, April 1978, pages 601-608, A.K. Sinha et al.
- Journall of the Electrochemical Society, vol. 114, No. 7, July 1967, pages 717-722, T. L. Chu et al.
- IBM Technical Disclosure Bulletin, vol. 16, No. 5, Oct. 1973, page 1442, J.J. Cuomo et al., US-A-4 277 540
- Journal of applied Physics, 53(3), March 1982, pages 2353-2355, R. Allen et al. and DE-A-3 110 583

## Description

The present invention relates to a magneto-optic memory device on and from which information can be recorded, reproduced and erased using light waves such as laser beams.

In recent years much effort has been put into studying and developing optical memory devices as their potential capability for high storage density and capacity has been appreciated. In particular, much attention has been given to those optical memory devices in which additional information can be recorded by the user (the recorded information being non-erasable) and those optical memory devices in which information can be recorded and erased by the user. Various recording mediums and optical memory systems have been proposed for such memory arrangements. The known recording mediums for the former optical memory devices include TeOx, TeSe, TeC, etc. Among the known recording mediums for the latter optical memory devices are GdTbFe, GdTbDyFe, TbFe, etc. Most of such recording mediums are poor in their resistance to corrosion and efforts which have heretofore been made to solve this problem have been mostly unsuccessful.

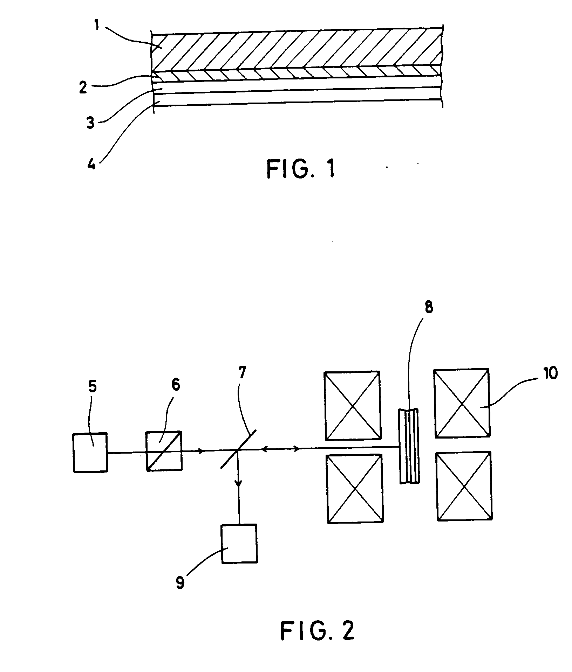

The difficulties which arise when the optical memory mediums suffer corrosion or oxidation will be described. The inventor has studied optical memory devices (so-called "magneto-optic memory devices") having a memory medium made of a rare earth/transition metal alloy and in which information can be recorded and erased by the user. FIG. 1 shows in detail the arrangement of one such conventional magneto-optic memory device. The illustrated magneto-optic memory device includes a glass substrate 1, a thin film 2 (recording medium) of amorphous alloy of GdTbFe having a thickness in the range from 100 to 200 x 10⁻¹⁰m (100 to 200 Å) deposited on the glass substrate 1 by sputtering, a film 3 of SiO₂ (transparent dielectric film) having a thickness ranging from 300 to 400 × 10⁻⁰m (300 to 400 Å) deposited on the thin film 2 by sputtering, and a film 4 of Cu (reflecting film) having a thickness ranging from 300 to 500 × 10⁻¹⁰m (300 to 500 Å) deposited on the film 3 by sputtering.

The characteristics of the magneto-optic memory device of the above construction have been measured by an optical system shown in FIG. 2 to determine the degree of dependence of a magneto-optic rotational angle on the magnetic field. As shown in FIG. 2, a monochromatic light beam such as a laser beam emitted from a light source 5 is changed by a polarizer 6 into a linearly polarized light beam, which passes through a half-mirror 7 and falls on a magneto-optic memory device 8 perpendicularly to its surface. The light beam enters the recording medium 2 of the magnetooptic memory device 8 through the glass substrate. A light beam reflected from the magneto-optic memory device 8 is deflected by the half-mirror 7 into a light detector 9 which detects the angle through which the plane of polarization of light is rotated. The magnetic field is rendered variable by an electromagnet 10.

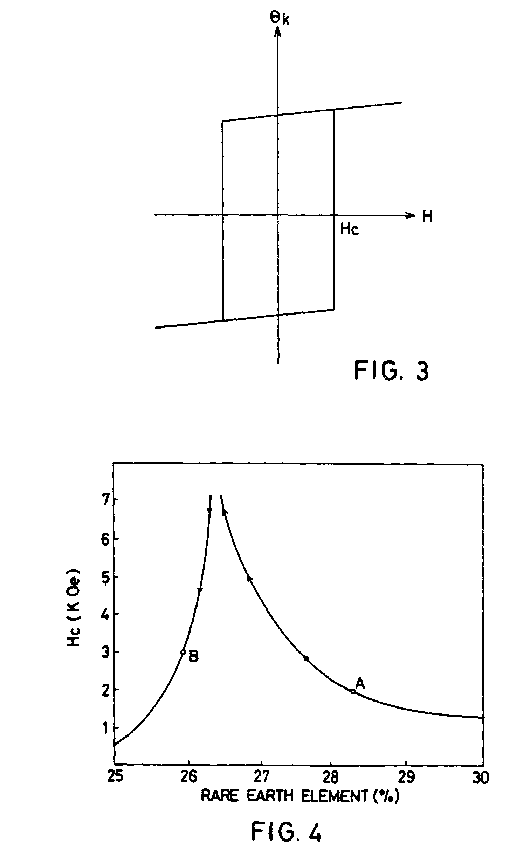

FIG. 3 illustrates the results of such measurement of the degree of dependence of the magneto-optic rotational angle on the magnetic field, obtained using the illustrated optical system. The graph of FIG. 3 has a horizontal axis indicating the intensity of a magnetic field H and a vertical axis indicating a Kerr rotational angle θk. Designated at Hc is the value of a coercive (magnetic force with which magnetization is inverted). The value of the coercive force is quite important in the magneto-optic memory device. If the coercive force were too large, an excessive amount of heat would be required for recording information, and no information could be recorded with a small-size laser such as a semiconductor laser. The magnetic field which would have to be applied for recording information would be excessively large. Conversely, if the coercive force were too small, recorded information would tend to be erased by a relatively small increase in the external temperature or the external magnetic field. As the coercive force of the recording medium varies with time, the values of the temperature and magnetic field necessary for information recording also vary in general. Therefore, it is desirable to keep the coercive force constant.

Where the recording medium of the above magneto-optic memory device is made of an alloy of rare earth elements and transition metal, the coercive force of the recording medium varies widely with the composition ratio of rare earth elements. FIG. 4 is a graph showing the relationship between the composition ratio of rare earth elements (Gd, Tb) and the coercive force in a thin film of amorphous alloy of GdTbFe. The graph has a horizontal axis indicative of an area ratio of the rare earth elements placed on an iron target upon sputtering. The elements Gd, Tb are equal in their amounts. FIG. 4 shows that the percentage of the rare elements in the thin film amorphous alloy of GdTbFe is about 26.3% at a compensation point of a room temperature. The magneto-optic effect (the Kerr rotational angle as shown in FIG. 3) is changed at the point where the percentage of the rare earth elements is about 26.3%. Where the percentage of the rare earth elements is greater than 26.3%, that is, the rare earth elements are relatively rich, the magneto-optic effect is progressively greater at the left in FIG. 4. Where the percentage of the rare earth elements is smaller than 26.3%, that is, the iron is relatively rich, the magneto-optic effect is progressively greater at the right in FIG. 4.

The inventor prepared a magneto-optic memory device having a recording medium of a composition as shown at the point A in FIG. 4. The prepared magneto-optic memory device device was left at 70°C for 42 hours to study its reliability. The composition of the recording medium changed to that shown at the point B where the coercive force Hc is about +2.4 × 10⁵ amp/m (3K Oe), in a manner as indicated by the arrowheads. This is assumed to be brought about by the fact that the rare earth elements (Gd, Tb) in the film of GdTbFe amorphous alloy are oxidized by oxygen which separates from the adjacent dielectric SiO₂ film, and the oxidized rare earth elements no longer contribute to the magnetic characteristics.

As described above, the construction of the conventional magneto-optic memory devices fail to prevent a time-dependent change in the composition of the recording medium due to oxidation, and hence is incapable of ensuring a constant coercive force.

Accordingly, the conventional magneto-optic memory devices cannot record information stably.

In our published French patent application No: 2485241, we describe a magneto-optic memory medium in which a layer of an optical memory recording medium comprising an amorphous rare earth-transition metal alloy is formed on a transparent substrate, a dielectric layer being overlaid on this recording layer, and a reflector layer being overlaid on the dielectric layer. In use, the dielectric layer acts to prevent heat escaping from the recording medium layer into the reflector layer, the latter serving to increase the Kerr rotation angle. Further increase of the Kerr rotation angle can be obtained by providing a further dielectric layer between the substrate and the recording medium layer. For each of the dielectric layers there is disclosed a number of materials which, for the overlying dielectric layer include oxide materials and MgF, and for the further dielectric layer include two oxides and ZnS. This prior art does not recognise the aforementioned problem of deterioration of the opto-magnetic characteristics of the recording medium due to oxidation and accordingly does not teach the selection of materials for the dielectric layer or layers specifically to avoid this problem.

Published European patent application 0062075 discusses the problem of oxidation by atmospheric oxygen of an optical recording medium of the type on which information can be recorded using a laser beam to form pits in the recording layer surface. The particular material disclosed for the recording layer is tellurium and the problem is alleviated by including carbon in the recording layer. The recording layer may be divided into two sub-layers, the carbon content being in only one of them. In one arrangement the Te layer is sandwiched between a Te-C layer and a Te-O layer. since this prior art is concerned only with recording by melt-deformation in the recording layer the problem of oxidation of an optical memory recording medium by oxygen from an adjacent dielectric layer is not recognized.

According to the present invention there is provided A magneto-optical memory device---(as claim 1).

The substrate is preferably made of a material selected from the group comprising glass, polycarbonate, acrylic resin and epoxy resin.

The dielectric layers are each preferably made from a material selected from the group consisting of AIN, Si₃N₄, MgF₂, ZnS, and CeF₃.3NaF.

The device preferably includes a reflecting layer, the first dielectric layer being sandwiched between said reflecting layer and the recording medium layer. In a particular embodiment the first dielectric layer is made of aluminium nitride and the reflecting layer is made of stainless steel.

There may be provided a covering layer formed on the reflecting layer, this covering layer being made of an easily oxidisable metal, or a rare earth metal or a rare earth/transition metal alloy.

Some embodiments of the invention will now be described by way of example with reference to Figures 5 to 9 of the accompanying drawings. In the drawings:-
FIG. 1 is a fragmentary cross-sectional view of a known magneto-optic memory device;
FIG. 2 is a schematic view of a measurement optical system;
FIG. 3 is a graph showing the degree of dependence of a magneto-optic rotational angle on applied magnetic fields;
FIG. 4 is a graph showing the relationship between a composition ratio of rare earth elements in a thin film GdTbFe amorphous alloy and a coercive force;
FIG. 5 is a fragmentary cross-sectional view of a magneto-optic memory device which is not in itself an embodiment of the invention but is described hereinafter by way of background to the present invention;
FIG. 6 is a graph showing the result of a storage test on the magneto-optic memory device illustrated in FIG. 5;
FIG. 7 is a fragmentary cross-sectional view of a magneto-optic memory device which again is not in itself an embodiment of the invention, but is described hereinafter by way of background to the invention;
FIG. 8 is a fragmentary cross-sectional view of a magneto-optic memory device according to an embodiment of the invention; and
FIG. 9 is a graph showing the result of an Auger electron spectroscopy of the magneto-optic memory device shown in FIG. 8.

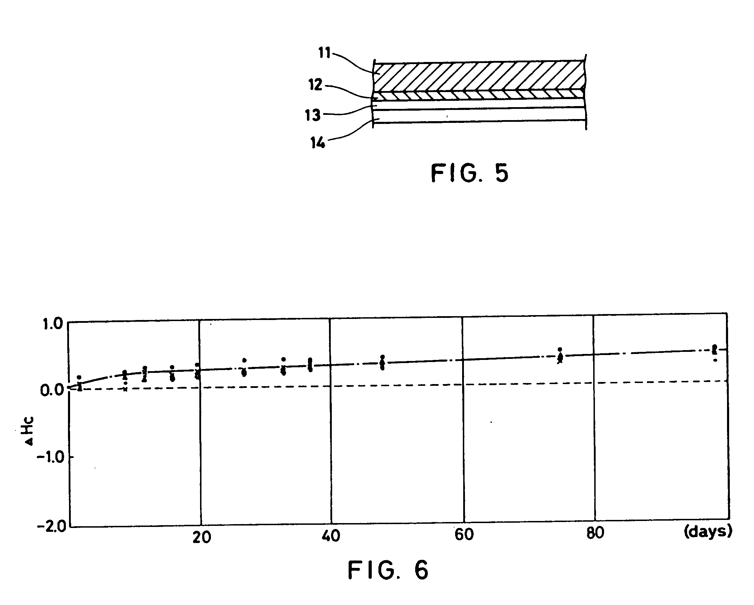

The magneto-optic memory device of Figure 5, which as mentioned above is not in itself an embodiment of the invention, includes a thin film 12 (serving as a recording medium) made of GdTbFe amorphous alloy having a thickness in the range of from about 150 to about 200 × 10⁻¹⁰m (150 to 200Å) deposited on a glass substrate 11 by sputtering. On the GdTbFe film 12, there is deposited a film 13 (serving as a transparent dielectric film) made of AIN (aluminium nitride) having a thickness ranging from about 400 to about 500 × 10⁻¹⁰m (400 to 500Å) by reactive sputtering of aluminium in nitrogen gas. A film 14 (serving as a reflecting film) of stainless steel (such as SUS 304) having a thickness ranging from about 500 to about 600 × 10¹⁰m (500 to 600Å) is deposited on the AIN film 13 by sputtering.

The inventor prepared four magneto-optic memory devices of the foregoing construction, and conducted a storage test on the memory devices at a temperature of 70°C. FIG. 6 illustrates the result of such a storage test, in which test results for the four memory devices are indicated by the marks o, x, , Δ, respectively. The mark Δ is superimposed on the mark in some instances. As shown in FIG. 6, the coercive force becomes slightly larger by about 3.2 × 10⁴ amp/m (0.4 kOe) than an initial coercive force (in the range of from about 1.4 to about 1.7 × 10⁵ amp/m (1.8 to about 2.2 kOe) after about 100 days of the storage test on the magneto-optic memory device. The increase in the coercive force is extremely small as compared with that in magneto-optic memory devices of a conventional structure. This is because the transparent dielectric film of aluminium nitride has no oxygen content in itself while conventional transparent dielectric films of SiO₂ have an oxygen content. Stated otherwise, when the transparent dielectric film is formed by way of reactive sputtering in a nitrogen gas using an aluminium target, there is no tendency for oxygen to enter the recording medium at the time the film is deposited. From this standpoint, the transparent dielectric film may be made of other materials with no oxygen content such as MgF₂, ZnS, CeF₃, AIF₃, 3NaF.

However, most targets comprising these materials are porous, so that if these materials are employed to fabricate the transparent dielectric film by conventional sputtering, oxygen and water penetrating into the pores in the materials are liable to oxidize the recording medium during sputtering. However, where the transparent dielectric film is made of aluminium nitride, the target used is of aluminium only and is advantageous from the standpoint of material savings. The aluminium target is not porous and hence does not trap therein oxygen and water. Due to its structural features, aluminium nitride can form very tight films which are impermeable to oxygen and water, a property which further inhibits oxidation of the recording medium.

It is highly advantageous to make the reflecting film 14 in the magnetooptic memory device from stainless steel. The advantages of making the reflecting film of stainless steel will be described below.

### (1) Corrosion resistance:

As is well known, stainless steel has excellent properties of resistance to corrosion. For example, no pinholes will be formed in a reflecting film of stainless steel when a fingerprint is put on the film, while a minute pinhole will be formed in a reflecting film of Cu at some later time after a fingerprint is impressed on the film. (In an experiment, no pinhole was formed in a reflecting film of Ni). The excellent corrosion resistance of stainless steel can contribute to the corrosion resistance capability of the recording medium.

### (2) Thermal conductivity:

Stainless steel has a poor thermal conductivity as compared with Cu, Au, Ag, Al. For this reason, when the recording medium is heated by a laser beam irradiated thereon, the heat conductivity is reduced and the laser beam energy required for information recording is reduced. Aluminium nitride of which the transparent dielectric film is made has relatively good thermal conductivity and hence allows much heat escape. Thus, while the transparent dielectric film is formed of aluminium nitride, the use of stainless steel for the reflecting film in combination therewith is particularly suitable.

### (3) Easy Film formation:

Since the sputtering of stainless steel is relatively easy, a stainless steel film can be easily made, and this is advantageous for fabrication purposes.

While in the above-described device the substrate 11 is formed of glass, it may be in the form of a transparent substrate of polycarbonate, acrylic resin, or epoxy resin, for example. The dielectric film may be formed of silicon nitride instead of aluminium nitride. The reflecting film 14 may be formed of Ni, Ti, or TiN instead of stainless steel.

Adaptation of the above described device by way of insertion of a transparent dielectric film with no oxygen content between the substrate and the recording medium film produces a structure according to the present invention.

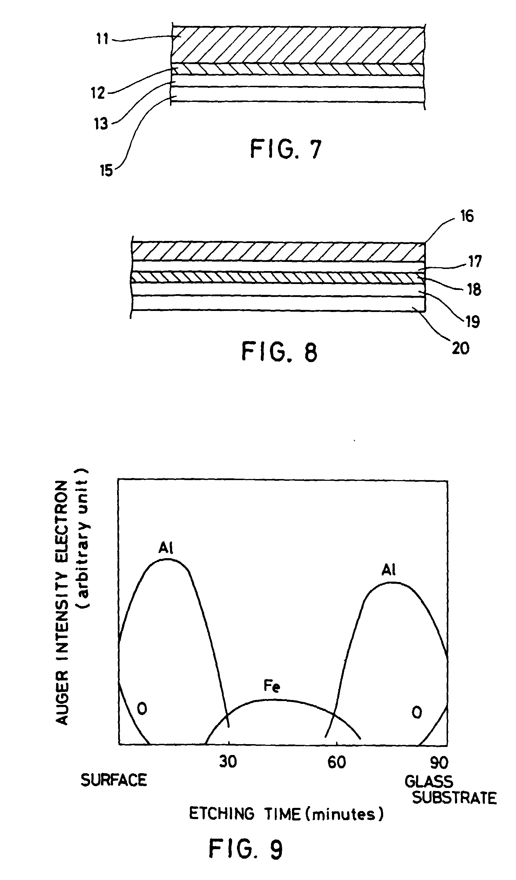

FIG. 7 is illustrative, in fragmentary cross section, of a magneto-optic memory device which again is not in itself an embodiment of the invention but which may readily be adapted as described later to produce another embodiment of the invention. The illustrated magneto-optic memory device includes a thin film 12 (serving as a recording medium) made of GdTbFe amorphous alloy having a thickness in the range of from about 150 to about 200 × 10⁻¹⁰m (150 to 200Å) deposited on a glass substrate 11 by sputtering. On the GdTbFe film 12, there is deposited a film 13 (serving as a transparent dielectric film) made of AIN (aluminium nitride) having a thickness ranging from about 400 to about 500 × 10⁻¹⁰m (400 to 500 Å) by reactive sputtering of aluminium in a nitrogen gas. A film 15 (serving as a reflecting film) of Ti (titanium) or TiN (titanium nitride) is deposited on the AIN film 13 by sputtering.

The reflecting film of titanium or titanium nitride exhibits the following advantages:

Where the dielectric film is made of aluminium nitride, it is difficult to cover the dielectric film with a conventional reflecting film of Cu, Al, or the like with a high reflectivity in a laser wavelength range (about 800 nm). This difficulty is thought to be due to the fact that the effect of nitrogen in the aluminium nitride on Cu or Al is significant. However, the reflecting film of titanium or titanium nitride can easily be deposited on the transparent dielectric film of aluminium nitride with a high reflectivity in the laser wavelength range. This allows a large amount of light to be reflected from the reflecting film, resulting in an improved reproduced signal. Another advantage is that if a reflecting film of titanium or titanium nitride is deposited by way of sputtering, the target used is made of Ti, which is relatively cheap and easily available.

Adaptation of the magneto-optic memory device described above with reference to figure 7 by way of inclusion of a transparent dielectric film of aluminium nitride between the glass substrate 11 and the thin film 12 of GdTbFe amorphous alloy so that the latter film can be sandwiched between two transparent dielectric films of aluminium nitride, produces another embodiment of the present invention. The glass substrate may be replaced with a substrate of polycarbonate, acrylic resin, epoxy resin or the like.

FIG. 8 shows a magneto-optical memory device according to still another embodiment of the present invention. A film 17 of aluminium nitride (serving as a first transparent dielectric film) is deposited on a transparent substrate 16 made as of glass, polycarbonate, acrylic resin or the like. On the film 17, there is formed a thin film 18 of rare earth/transition metal alloy such as GdTbFe, TbDyFe, GdTbFe, TbFe, GdFeCo, GdCo, or of such alloys with a content of Sn, Zn, Si, Bi, B or the like. In addition, a transparent film 19 of aluminium nitride (serving as a second transparent dielectric film) is deposited on the thin film 18. A reflecting film 20 of Cu, Ag, Al, Au or the like is formed on the transparent film 19. The magneto-optic memory device of the above structure is subjected to an Auger electron spectroscopy. FIG. 9 shows the result of such an Auger electron spectroscopy, indicating Auger electron intensities in Al, Fe, O of the three films, that is, the film of aluminium nitride, the film of GdTbFe, and the film of aluminium nitride. As illustrated, no oxygen is contained in the GdTbFe film, and a slight amount of oxygen is present in the interface between the surface and the film of aluminium nitride and the interface between the film of aluminium nitride and the transparent substrate. This indicates that there is oxygen entered into the film of aluminium nitride from the exerior and into the film of aluminium nitride from the glass substrate after the films have been fabricated. This experimental result shows that the sandwich structure of the thin film 18 of rare earth/transition metal alloy between the films of aluminium nitride is effective to prevent the thin film 16 from being oxidized during the process of fabricating the films.

Instead, of aluminium nitride, the transparent dielectric films may be formed of Si₃N₄ by way of reactive sputtering in a nitrogen gas using an Si target. The transparent dielectric films may be formed of MgF₂, ZnS, CeF₃ 3NaF by vacuum deposition.

The first transparent dielectric film in the above magneto-optical memory device should be of a thickness of at least 100 × 10⁻¹⁰m (100Å) for the reason which follows: When the first transparent dielectric film is deposited on the glass substrate, oxygen in the glass substrate enters the first transparent dielectric film to the depth of about 50 × 10⁻¹⁰m (50Å). If the thickness of the first transparent dielectric film were smaller than 100 × 10⁻¹⁰m (100Å), it would be possible for oxygen to find its way into the thin film of rare earth/ transition metal alloy when the latter is being sputtered on the first transparent dielectric film. The second transparent dielectric film is deposited mainly for the purposes of increasing the magneto-optic rotational angle and improving the quality of reproduced signals. The reflecting film 20 in the magneto-optic memory device of FIG. 8 may be covered with a film of an easily oxidizable metal such as Ti, Mg, a rare earth metal (Gd, Tb, Dy, Ho, Y, etc.), or an alloy of a rare earth element and transition metal (GdTbFe, TbDyFe, GdCo, GdTbDyFe, etc.) to provide a complete device construction which prevents entry of oxygen from the exterior.

The film of aluminium nitride serving as a transparent dielectric film may be formed by deposition or other fabrication processes. The thicknesses of the films in the magneto-optic memory device are not limited to those described above in the illustrated embodiments.

## Claims

1. A magneto-optical memory device having a layer of an optical memory recording medium (18) comprising an amorphous rare earth/transition metal alloy sandwiched between a first dielectric layer (19) and a further dielectric layer (17), said further dielectric layer (17) being disposed between said optical memory recording medium layer (18) and a transparent substrate (16) of the device, characterised in that each of said dielectric layers (17, 19) is substantially impermeable to oxygen, and also has substantially no oxygen content whereby substantially to prevent oxygen from entering said recording medium layer, and thereby to inhibit change with time of its characteristics due to selective oxidation of the rare earth component of said rare earth/transition metal alloy.

2. An optical memory device according to claim 1, wherein said transparent substrate (16) is made of a material selected from the group comprising glass, polycarbonate, acrylic resin and epoxy resin.

3. An optical memory device according to claim 1 or claim 2, wherein said further dielectric layer (17) is at least 100 × 10⁻¹⁰m (100Å) thick, thereby to prevent oxygen from the transparent substrate (16) from reaching the optical memory recording medium layer.

4. An optical memory device according to any preceding claim, wherein each of said dielectric layers is made from a material selected from the group consisting of aluminium nitride, silicon nitride, MgF₂, ZnS and CeF₃.3NaF.

5. An optical memory device according to any preceding claim, wherein said rare earth/transition metal alloy is GdTbFe.

6. An optical memory device according to any preceding claim, further including a reflecting layer (20) , said first dielectric layer (19) being sandwiched between said reflecting layer and said recording medium layer (18).

7. An optical memory device according to claim 6, wherein said reflecting layer (20) is made from a material selected from the group consisting of Cu, Ag, Al, and Au.

## Patentansprüche

1. Magnetooptische Speichereinrichtung mit einer Schicht aus einem eine Seltenerdmetall/Übergangsmetall-Legierung umfassenden optischen Speichermedium (18), welches zwischen einer ersten dielektrischen Schicht (19) und einer weiteren dielektrischen Schicht (17) angeordnet ist, wobei die weitere dielektrische Schicht (17) zwischen der Schicht aus dem optischen Speichermedium (18) und einem transparenten Substrat (16) der Einrichtung vorgesehen ist, **dadurch gekennzeichnet**, daß jede der dielektrischen Schichten (17, 19) im wesentlichen für Sauerstoff undurchlässig ist und ebenso im wesentlichen keinen Sauerstoffgehalt aufweist, wodurch im wesentlichen verhindert wird, daß Sauerstoff die Schicht aus dem Speichermedium erreicht, und dadurch verhindert wird, daß mit der Zeit Änderungen ihrer Eigenschaften als Folge einer selektiven Oxidation der Seltenerdmetallkomponente der Seltenerdmetall/Übergangsmetall-Legierung auftreten.

2. Optische Speichereinrichtung nach Anspruch 1, wobei das transparente Substrat (16) aus einem Material gebildet ist, welches aus der Glas, Polycarbonat. Acrylharz und Epoxyharz umfassenden Gruppe ausgewählt ist.

3. Optische Speichereinrichtung nach Anspruch 1 oder 2, wobei die weitere dielektrische Schicht (17) eine Dicke von mindestens 100 × 10⁻¹⁰m (100 Å) aufweist, um zu verhindern, daß Sauerstoff aus dem transparenten Substrat (16) die Schicht aus dem optischen Speichermedium erreicht.

4. Optische Speichereinrichtung nach einem der vorangehenden Ansprüche, wobei jede der dielektrischen Schichten aus einem Material gebildet ist, welches aus der Aluminiumnitrid, Siliciumnitrid, MgF₂, ZnS und CeF₃.3NaF umfassenden Gruppe ausgewählt ist.

5. Optische Speichereinrichtung nach einem der vorangehenden Ansprüche, wobei die Seltenerdmetall/Übergangsmetall-Legierung GdTbFe ist.

6. Optische Speichereinrichtung nach einem der vorangehenden Ansprüche, umfassend weiterhin eine reflektierende Schicht (20), wobei die erste dielektrische Schicht (19) zwischen der reflektierenden Schicht und der Schicht (18) aus dem Speichermedium angeordnet ist.

7. Optische Speichereinrichtung nach Anspruch 6, wobei die reflektierende Schicht (20) aus einem Material gebildet ist, welches aus der Cu, Ag, Al und Au umfassenden Gruppe ausgewählt ist.

## Revendications

1. Dispositif de mémoire magnéto-optique ayant une couche d'un support d'enregistrement de mémoire optique (18), comprenant un alliage amorphe terre rare/métal de transition pris en sandwich entre une première couche diélectrique (19) et une couche diélectrique supplémentaire (17), ladite couche diélectrique supplémentaire (17) étant disposée entre ladite couche de support d'enregistrement de mémoire optique (18) et up substrat transparent (16) du dispositif, caractérisé en ce que chacune desdites couches diélectriques (17, 19) est pratiquement imperméable à l'oxygène et en outre est pratiquement exempte d'oxygène pour empêcher l'oxygène de pénétrer dans ladite couche de support d'enregistrement, et ainsi inhiber une modification au cours du temps de ses caractéristiques due à l'oxydation sélective du composant terre rare dudit alliage terre rare/métal de transition.

2. Dispositif de mémoire optique selon la revendication 1, dans lequel ledit substrat transparent (16) est constitué d'un matériau sélectionné dans le groupe comprenant le verre, un polycarbonate, une résine acrylique et une résine époxy.

3. Dispositif de mémoire optique selon la revendication 1 ou la revendication 2, dans lequel ladite couche diélectrique supplémentaire (17) est d'une épaisseur d'au moins 100 × 10⁻¹⁰m (100Å), de manière à empêcher l'oxygène provenant du substrat transparent (16) d'atteindre la couche de support d'enregistrement de mémoire optique.

4. Dispositif de mémoire optique selon l'une quelconque des revendications précédentes, dans lequel chacune desdites couches diélectriques est constituée d'un matériau sélectionné dans le groupe constitué par nitrure d'aluminium, nitrure de silicium, MgF₂, ZnS et CeF₃.3NaF.

5. Dispositif de mémoire optique selon l'une quelconque des revendications précédentes, dans lequel ledit alliage terre rare/métal de transition est GdTbFe.

6. Dispositif de mémoire optique selon l'une quelconque des revendications précédentes, comprenant en outre une couche réfléchissante (20), ladite première couche diélectrique (19) étant prise en sandwich entre ladite couche réfléchissante et ladite couche de support d'enregistrement (18).

7. Dispositif de mémoire optique selon la revendication 6, dans lequel ladite couche réfléchissante (20) est constituée d'un matériau sélectionné dans le groupe constitué de Cu, Ag, Al et Au.
